# EUROPÄISCHE PATENTSCHRIFT

(11) **EP 1 111 864 B1**
(45) Veröffentlichungstag und Bekanntmachung des Hinweises auf die Patenterteilung: **01.03.2006**
(21) Anmeldenummer: 00123592.8
(22) Anmeldetag: 28.10.2000
(51) Int. Cl.: H04L 25/49, G06T 9/00, H03M 7/46, G06F 13/42

(54) **Kodierung von Haupt- und Zusatzinformationen in einem Bussystem**
Coding of main and secondary information for a bus system
Codage d'information principale et secondaire pour un système de bus

(30) Priorität: 24.12.1999 DE 19962971
(43) Veröffentlichungstag der Anmeldung: 27.06.2001
(73) Patentinhaber: ROBERT BOSCH GMBH, 70442 Stuttgart (DE)
(72) Erfinder: Meroth, Ansgar, 72766 Reutlingen (DE); Geisler, Thomas, 76133 Karlsruhe (DE)

(56) Entgegenhaltungen:
- EP-A- 0 581 713
- US-A- 5 831 559
- "ENHANCED SYSTEMS NETWORK ARCHITECTURE DATA COMPRESSION" IBM TECHNICAL DISCLOSURE BULLETIN, IBM CORP. NEW YORK, US, Bd. 33, Nr. 5, 1. Oktober 1990 (1990-10-01), Seiten 396-397, XP000107572 ISSN: 0018-8689

## Beschreibung

### STAND DER TECHNIK

Die vorliegende Erfindung betrifft ein Verfahren zur Datenübertragung über ein Bussystem von einer Datenquelle zu einer Datensenke.

Es werden nach dem Stand der Technik eine Vielzahl einsatzbereiter Multimedia-Bussysteme für die gleichzeitige Datenübertragung von mehreren Bild- und Tonkanälen verwendet. Jedoch sind die meisten dieser Bussysteme für den KFZ-Bereich nicht geeignet, da sie technisch zu aufwendig sind und eine zu geringe Störfestigkeit gegenüber Erschütterungen, Temperaturschwankungen und anderen externen Einflüssen besitzen Zusätzlich weisen diese Systeme für den KFZ-Bereich zu große Bauteile auf und finden daher in dieser Branche keine Anwendung.

Speziell für einen Einsatz im KFZ-Bereich, in dem Komponenten mit geringerem temporären und festen Speicher eingesetzt werden, existiert nach dem Stand der Technik das D2B-Bussystem bzw. dessen Nachfolger, das MOST(Media Oriented Systems Transport)-Bussystem. Die wichtigsten Systemparameter des MOST-Busses sind allerdings auf eine Datenübertragung von Tondaten ausgelegt.

Die der vorliegenden Erfindung zu Grunde liegende Problematik besteht allgemein darin, eine Datenübertragung von Bilddaten von einer Datenquelle zu einer Datensenke über ein im KFZ-Bereich verwendbares Bussystem zu schaffen, bei dem die bei einer Datenübertragung über einen synchronen Bus notwendigen Zusatzinformationen in das vorhandene Datenprotokoll leicht integrierbar sind.

Im Stand der Technik finden sich folgende Ansätze zur Lösung dieses Problems.

Mittels eines MPEG(Motion Picture Expert Groups)-Kompressionsverfahrens kann eine Datenübertragung auch von bewegten Bildern erfolgen.

Bei diesem Ansatz hat sich die Tatsache als nachteilhaft herausgestellt, dass das MPEG-Kompressionsverfahren verlustbehaftet und somit nicht zur Datenübertragung hochwertiger GUI (Graphical User Interface)-Graphiken geeignet ist. Außerdem ist die Komprimierung beim MPEG-Kompressionsverfahren sehr aufwendig.

Bei einem weiteren Ansatz zur Datenübertragung von pixelorientierten Bilddaten über den MOST-Bus wird auch zusätzlich ein Kompressionsverfahren, nämlich der Lempel-Ziv-Alghorithmus, eingesetzt. Bei diesem Verfahren wird eine zu komprimierende Datenfolge auf Wiederholungen von Teilfolgen hin untersucht, wobei sich wiederholende Elemente in einer Code-Tabelle gespeichert werden und eine Ersetzung der Teilfolgen durch ein zugewiesenes Codezeichen erfolgt.

Als nachteilhaft bei diesem bekannten Ansatz ergibt sich die Tatsache, dass zur Dekomprimierung eine Tabelle unbekannter Größe angelegt werden muss. Das Arbeiten mit größeren temporären Tabellen ist unvorteilhaft für eine Implementierung in Embedded-Systemen.

Ein weiterer Ansatz sieht schließlich eine Kompression mittels einem Lauflängen-Kodierungs-Verfahren (engl.: RUN-LENGTH-ENCODING), im Folgenden als RLE-Verfahren bezeichnet, vor. Wird ein nach einem RLE-Verfahren komprimierter Datenstrom über ein Bussystem übertragen, so müssen diesem gewisse Zusatzinformationen beigefügt werden, um sinnvoll von einer Datensenke verarbeitet werden zu können.

Aus der EP 581 713 A2 ist ein Verfahren zur Lauflängen-Kodierung bekannt, bei der ein erstes Datenelement in einem Code-Bereich und in einen Zählerbereich aufgetrennt ist. Je nach Setzen des Code-Bereiches wird entweder ein Wiederholungsfaktor für ein nachfolgendes Datenelement angegeben oder ein Master-Zeichen für die Kodierung wird verändert.

### Vorteile der Erfindung

Das erfindungsgemäße Verfahren mit den Merkmalen des Anspruchs 1 weist gegenüber den bekannten Lösungsansätzen den Vorteil auf, dass es ein einfaches Datenprotokoll für synchrone Datenbusse und eine einfache und robuste Datenübertragung von pixelorientierten Bilddaten, insbesondere von komprimierten Daten, mit bestimmten Zusatzinformationen über ein Bussystem liefert. Ein vorhandenes Datenformat, wie es innerhalb eines Embedded-Systems temporär oder fest abgespeichert vorliegt, wird durch geringe Modifikationen busfähig gemacht, wobei das modifizierte Datenformat dabei kompatibel zum ursprünglichen Datenformat ist.

Die der vorliegenden Erfindung zu Grunde liegende Idee besteht darin, dass das Verfahren zur Datenübertragung über ein Bussystem ein Festlegen mindestens eines vorbestimmten Wiederholfaktors in dem ersten Datenelement als Kennzeichnung für das Vorliegen einer Zusatzinformation, wobei das zweite Datenelement die Zusatzinformation enthält.

Dadurch ist ein einfaches Datenprotokoll geschaffen, mit dem Zusatzinformationen zu einem komprimierten Datenstrom über ein Bussystem auf elegante Weise mit übertragen werden. So werden vorbestimmte Wiederholfaktoren dem bestimmten Code zugeordnet, um das spezielle Protokoll zu verwirklichen. Dies ermöglicht ein einfaches Datenprotokoll z.B. für synchrone Bussysteme. Die zusätzliche Datenmenge aufgrund der Zusatzinformationen kann so reduziert werden.

In den Unteransprüchen finden sich vorteilhafte Weiterbildungen und Verbesserungen des in Anspruch 1 angegebenen Datenübertragungsverfahrens.

Gemäß einer bevorzugten Weiterbildung sind die Wiederholfaktoren natürliche Zahlen in einem Intervall von "0" bis "255". Dies ergibt sich aus den 256 verschiedenen Datenwerten in einem aus 8 Bit bestehenden Byte.

Gemäß einer weiteren Ausgestaltung ist der vorbestimmte Wiederholfaktor als Kennzeichnung für das Vorliegen einer Zusatzinformation vorzugsweise "0" und/oder "1". Durch diese Modifikation wird eine Codierung vorzugsweise durch die Wiederholfaktoren vorgenommen, die als Kennzeichnung einer Wiederholung eines bestimmten Datums ohnehin keinen Sinn ergeben.

Gemäß einer weiteren bevorzugten Weiterbildung werden von "0" und/oder "1" verschiedene weitere Wiederholfaktoren als Kennzeichnung für das Vorliegen einer Zusatzinformation verwendet, die vorzugsweise im oberen Bereich des oben erwähnten Intervalls liegen. Dadurch stehen für den Fall, dass zwei Wiederholfaktoren nicht ausreichen, zusätzliche Wiederholfaktoren zur Verfügung. Da Daten meistens mit kleineren Wiederholungen auftreten, sind insbesondere höhere Wiederholfaktoren auszuwählen.

Nach einer weiteren bevorzugten Ausgestaltung wird das Verfahren zur Datenübertragung komprimierter Daten eingesetzt. Dabei sind die zu übertragenden Daten als z.B. pixelorientierte Bilddaten ausgebildet. Somit ist eine Datenübertragung von komprimierten Bilddaten gewährleistet.

Gemäß einer weiteren bevorzugten Ausgestaltung ist das Bussystem als synchrones MOST-Bussystem ausgebildet. Dieses Bussystem ist insbesondere für eine Anwendung im KFZ-Bereich vorgesehen.

Gemäß einer weiteren bevorzugten Weiterbildung stellen die Zusatzinformationen unter anderem den Beginn oder das Ende einer logischen Dateneinheit, ein neutrales Datenelement zum Auffüllen, den Absender oder Empfänger einer Dateneinheit, zusätzliche Informationen über die Art der benutzten Lauflängen-Kodierung, zusätzliche Information zur Fehlererkennung oder zusätzliche Informationen zum allgemeinen Busmanagement dar. Solche Zusatzinformationen müssen zusammen mit dem komprimierten Datenstrom über ein synchrones Bussystem übertragen werden, damit die gesendeten Daten von der Datensenke entsprechend verarbeitet werden können.

### ZEICHNUNGEN

Ausführungsbeispiele der Erfindung sind in der Zeichnung und der nachfolgenden Beschreibung näher erläutert.

Es zeigt:

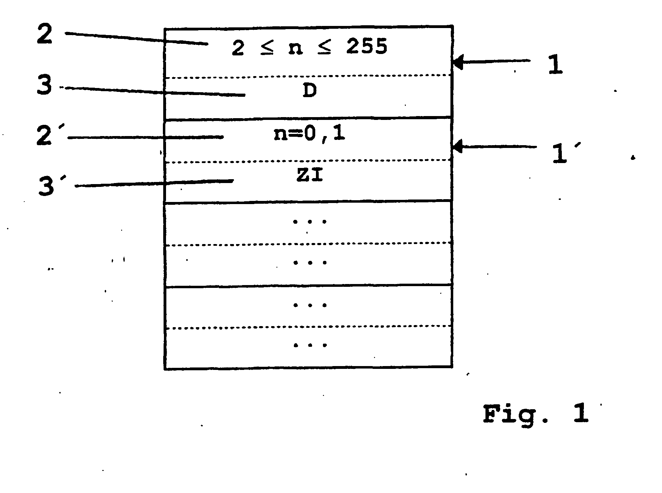

- Fig. 1: eine Prinzipdarstellung des erfindungsgemäßen Verfahrens als Ausführungsbeispiel der vorliegenden Erfindung.

### BESCHREIBUNG DER AUSFÜHRUNGSBEISPIELE

Fig. 1 illustriert das Prinzip des erfindungsgemäßen Verfahrens gemäß einem Ausführungsbeispiel der vorliegenden Erfindung. Die einzelnen Dateneinheiten 1; 1' eines Datenpaketes sind aus zwei Datenelementen 2, 3; 2', 3' aufgebaut. Dabei weist das erste Datenelement 2 der Dateneinheit 1 einen Wiederholfaktor n eines Datum D auf, wobei das entsprechende Datum D in dem zweiten Datenelement 3 der Dateneinheit 1 gespeichert ist.

Gemäß dem Ausführungsbeispiel der vorliegenden Erfindung wird als Kennzeichnung für das Vorliegen einer Zusatzinformation ZI die Wiederholfaktor m = 0, 1, vorbestimmt. Dabei sind in dem ersten Datenelement 2' die jeweiligen vorbestimmten Wiederholfaktoren m, in diesem Ausführungsbeispiel m = 0 und 1, und die entsprechende Zusatzinformation ZI in dem zweiten Datenelement 3' der Dateneinheit 1 gespeichert. Im folgenden wird der Ablauf des Verfahrens gemäße einem Ausführungsbeispiel der vorliegenden Erfindung erläutert.

Die von einer Datenquelle an eine Datensenke gesendeten Daten werden mittels einem RLE-Verfahren komprimiert, bei dem kein Datenverlust auftritt. Gegenstand des Verfahrens ist es, sich wiederholende Datenelemente zusammenzufassen und mit der Anzahl der Wiederholungen zu speichern. RLE-komprimierte Datensätze enthalten demnach Einheiten 1, die aus einem ersten Datenelement 2 zur Speicherung des Wiederholfaktors n eines abzuspeichernden Datums D und aus einem zweiten Datenelement 3 bestehen, in dem das abzuspeichernde Datum D tatsächlich abgelegt ist. RLE-komprimierte Datensätze können außerdem Strukturelemente zur Kennzeichnung besitzen, ob ein Datum D bzw. aufeinanderfolgende Daten mittels Wiederholfaktor n und zu wiederholendem Datum D kodiert werden oder ob ein Datum D ohne einen zugehörigen Wiederholfaktor zu interpretieren ist. Das RLE-Verfahren ist ein Format, welches die zu übertragenden Daten z.B. byteweise organisiert.

Bei diesem Ausführungsbeispiel wird ein komprimierter Datenstrom über ein synchrones Bussystem mittels dem RLE-Verfahren übertragen, wobei, wie oben bereits erwähnt, bestimmte Zusatzinformationen notwendig, damit eine Datensenke die gesendeten Daten verwerten kann. Denn bei einem synchronen Bussystem, wie zum Beispiel dem MOST-Bussystem, werden andauernd Daten mit einer konstanten Datenrate ohne jegliche Unterbrechung gesendet, da es in erster Linie für einen Audiodatenstrom gedacht ist. Solche Synchronbusse besitzen keine ausgezeichneten Momente, so dass bestimmte zusätzliche Informationen unerlässlich sind.

Solche Zusatzinformationen ZI sind zum Beispiel der Beginn oder das Ende einer logische Dateneinheit, zum Beispiel eines einzelnen Datenbildes, ein neutrales Datenelement zum Auffüllen, welches bei synchronen Bussen, über die augenblicklich keine Nutzdaten gesendet werden, eine wichtige Funktion darstellen, ein Absender oder ein Empfänger einer Dateneinheit oder sie können Zusatzinformationen ZI über die Art des benutzten RLE-Verfahrens, Zusatzinformationen ZI zur Fehlererkennung oder Zusatzinformationen ZI zum allgemeinen Busmanagement darstellen.

Mit Hilfe dieser Zusatzinformationen ZI können die übertragenen Daten D ausgewertet und sinnvoll verarbeitet werden.

Es ist nun eine Kennzeichnung notwendig, ob es sich um eine Aufzählung "Wiederholfaktor n - Datum D" handelt oder ob eine "Zusatzinformation ZI" im folgenden Byte vorliegt.

Dabei geht man wie folgt vor:

Die Wiederholfaktoren n sind natürliche Zahlen in einem Intervall I von "0" bis "255", da ein Byte mit acht Bit insgesamt 256 verschiedene Werte aufweisen kann. Der Wiederholfaktor "0" ergibt prinzipbedingt keinen Sinn und kommt somit nicht vor. Ebenso liefert der Wiederholfaktor "1" keinen zusätzlichen Hinwies, falls das Format derart deutlich definiert ist, das ein einzeln vorkommendes Datum D, welches nicht komprimierbar ist, einzeln aufgeführt und nicht mit einem Wiederholfaktor n versehen wird.

Somit stehen zumindest die beiden Wiederholfaktoren "0" und/oder "1" als Kennzeichnung für das Vorliegen einer Zusatzinformation ZI zur Verfügung. Die den RLE-Daten beigefügten Zusatzinformationen ZI werden nun in Datenworte kodiert und bestehen aus dem ersten Datenelement 2' und dem Datenelement 3', wobei in dem entsprechenden Format als Ausführungsbeispiele der vorliegenden Erfindung die Wiederholfaktoren m=0 und/oder m=1 derart vorbestimmt sind, dass sie das Vorliegen einer folgenden Zusatzinformation ZI kennzeichnen. In dem entsprechenden Datenelement 3' ist die eigentliche Zusatzinformation ZI gespeichert.

Reicht der Wiederholfaktor "0" zur Kennzeichnung nicht aus, so können weitere Wiederholfaktoren m aus dem Intervall I für die Kennzeichnung vorbestimmt werden, dass eine Zusatzinformation ZI folgt. In dem Ausführungsbeispiel der vorliegenden Erfindung wurde der Wiederholfaktor "1" mit vorbestimmt, da dieser wie oben bereits beschrieben dann nutzlos wird, wenn das Datenelement, welches das eigentliche Datum D enthält, als alleinstehend ohne jeglichem Wiederholfaktor n gekennzeichnet ist.

Sind diese beiden Wiederholfaktoren "0" und /oder "1" nicht ausreichend als Kennzeichnung für das Vorliegen einer Zusatzinformation ZI, so werden von "0" und /oder "1" verschiedene weitere Wiederholfaktoren m als Kennzeichnung verwendet, die geeigneterweise im oberen Bereich des Intervalls I liegen. Da erfahrungsgemäß Wiederholfaktoren mit kleineren Werten häufiger Verwendung finden als Wiederholfaktoren mit größeren Werten, werden vorzugsweise die Faktoren 255, 254, 253... usw. als zusätzliche Wiederholfaktoren m ausgewählt.

Die obige Ausführungsform der vorliegenden Erfindung schafft ein Verfahren zur Datenübertragung, mit dem vorteilhaft komprimierte pixelorientierte Bilddaten über einen synchronen MOST-Bus mit entsprechenden Zusatzinformationen übertragbar sind. Dabei wird ein vorhandenes Datenformat durch geringe Modifikationen busfähig gemacht, wobei das modifizierte Datenformat kompatibel zum ursprünglichen Datenformat ist.

Besonders vorteilhaft ist es dabei, das Verfahren für die Datenübertragung über den MOST-Bus zu einer Instrumentenanzeige in einem Kraftfahrzeug zu verwenden, da schon allein aus Gründen der Übersichtlichkeit eine graphische Darstellung möglichst einfacher Struktur gewählt werden muss.
Durch diese einfache Struktur der anzuzeigenden Bilddaten sind Wiederholungen gleicher Datenelemente besonders häufig.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

Insbesondere ist die Erfindung auf beliebige Busstruktüren anwendbar, welche eine Lauflängen-Kodierung zulassen.

## Patentansprüche

1. Verfahren zur Datenübertragung über ein Bussystem von einer Datenquelle zu einer Datensenke mit folgenden Schritten:
Lauflängen-Kodieren der zu übertragenden Daten, wobei Dateneinheiten (1; 1') mit zwei Datenelementen (2, 3; 2', 3') verwendet werden, von denen das erste Datenelement (2) einen Wiederholfaktor (n) eines Datums (D) und das zweite Datenelement (3) das entsprechende Datum (D) enthält,
**dadurch gekennzeichnet, dass**
mindestens ein vorbestimmter Wiederholfaktor (m) in dem ersten Datenelement (2') als Kennzeichnung für das Vorliegen einer Zusatzinformation (ZI) festgelegt wird, wobei das zweite Datenelement (3') die Zusatzinformation (ZI) enthält.

2. Verfahren nach Anspruch 1, **dadurch gekennzeichnet, dass** die Wiederholfaktoren (n; m) natürliche Zahlen in einem Intervall (I) von "0" bis "255" sind.

3. Verfahren nach einem der Ansprüche 1 oder 2, **dadurch gekennzeichnet, dass** der vorbestimmte Wiederholfaktor (m) als Kennzeichnung für das Vorliegen einer Zusatzinformation (ZI) vorzugsweise "0" und/oder "1" ist.

4. Verfahren nach Anspruch 2, **dadurch gekennzeichnet, dass** von "0" und/oder "1" verschiedene weitere Wiederholfaktoren (m) als Kennzeichnung für das Vorliegen einer Zusatzinformation (ZI) verwendet werden, die vorzugsweise im oberen Bereich des Intervalls (I) liegen.

5. Verfahren nach einem der vorangehenden Ansprüche, **dadurch gekennzeichnet, dass** das Verfahren zur Datenübertragung komprimierter Daten eingesetzt wird.

6. Verfahren nach einem der vorangehenden Ansprüche, **dadurch gekennzeichnet, dass** die zu übertragenden Daten als pixelorientierte Bilddaten ausgebildet sind.

7. Verfahren nach einem der vorangehenden Ansprüche, **dadurch gekennzeichnet, dass** das Bussystem als synchrones MOST(Media Oriented Systems Transport)-Bussystem ausgebildet ist.

8. Verfahren nach einem der vorangehenden Ansprüche, **dadurch gekennzeichnet, dass** die Zusatzinformationen (ZI) unter anderem den Beginn oder das Ende einer logischen Dateneinheit, ein neutrales Datenelement zum Auffüllen, den Absender oder Empfänger einer Dateneinheit, zusätzliche Informationen über die Art der benutzten Lauflängen-Kodierung, zusätzliche Informationen zur Fehlererkennung oder zusätzliche Informationen zum allgemeinen Busmanagement darstellen.

## Claims

1. Method for data transmission via a bus system from a data source to a data sink, having the following steps:
run-length encoding of the data to be transmitted, with data units (1; 1') having two data elements (2, 3;, 2', 3') being used, the first data element (2) of which contains a repetition factor (n) for a data item (D) and the second data element (3) of which contains the corresponding data item (D),
**characterized in that**
at least one predetermined repetition factor (m) in the first data element (2') is stipulated as an identifier for the presence of an additional information item (ZI), with the second data element (3') containing the additional information item (ZI).

2. Method according to Claim 1, **characterized in that** the repetition factors (n; m) are natural numbers in a range (I) from "0" to "255".

3. Method according to either of Claims 1 or 2, **characterized in that** the predetermined repetition factor (m) as an identifier for the presence of an additional information item (ZI) is preferably "0" and/or "1".

4. Method according to Claim 2, **characterized in that** further repetition factors (m) which differ from "0" and/or "1" are used as an identifier for the presence of an additional information item (ZI) which are preferably in the upper region of the range (I).

5. Method according to one of the preceding claims, **characterized in that** the method is used for data transmission of compressed data.

6. Method according to one of the preceding claims, **characterized in that** the data to be transmitted are in the form of pixel-oriented image data.

7. Method according to one of the preceding claims, **characterized in that** the bus system is in the form of a synchronous MOST (Media Oriented Systems Transport) bus system.

8. Method according to one of the preceding claims, **characterized in that** the additional information items (ZI) represent, inter alia, the start or end of a logical data unit, a neutral data element for filling, the sender or receiver of a data unit, additional information about the type of run-length encoding used, additional information relating to error recognition or additional information relating to the general bus management.

## Revendications

1. Procédé pour le transfert de données via un système de bus en partant d'une source de données vers une sortie de données avec les étapes suivantes :
coder les longueurs de projection des données à transférer, des unités de données (1 ; 1') étant utilisées avec deux éléments de données (2, 3 ; 2', 3'), le premier élément de données (2) comprenant un facteur de répétition (n) d'une date (D) et le deuxième élément de données (3) la date correspondante (D),
**caractérisé en ce qu'**
au moins un facteur de répétition (m) donné est déterminé dans le premier élément de données (2') en tant que caractéristique pour l'existence d'une information secondaire (ZI), le deuxième élément de données (3') comprenant l'information secondaire (ZI).

2. Procédé selon la revendication 1,
**caractérisé en ce que**
les facteurs de répétition (n ; m) sont des chiffres naturels dans un intervalle (I) de « 0 » à « 255 ».

3. Procédé selon l'une quelconque des revendications 1 ou 2,
**caractérisé en ce que**
le facteur de répétition (m) prédéfini sert de caractéristique pour l'existence d'une information secondaire (ZI), de préférence « 0 » et/ou « 1 ».

4. Procédé selon la revendication 2,
**caractérisé en ce que**
d'autres facteurs de répétition (m) que « 0 » et/ou « 1 » sont utilisés en tant que caractéristique pour l'existence d'une information secondaire (ZI) qui est de préférence comprise dans la plage supérieure de l'intervalle (I).

5. Procédé selon l'une quelconque des revendications précédentes,
**caractérisé en ce que**
le procédé est employé pour le transfert de données compressées.

6. Procédé selon l'une quelconque des revendications précédentes,
**caractérisé en ce que**
les données à transférer sont configurées sous forme de données image pixellisées.

7. Procédé selon l'une quelconque des revendications précédentes,
**caractérisé en ce que**
le système de bus est conçu en tant que système synchrone de bus MOST (Media Oriented Systems Transport).

8. Procédé selon l'une quelconque des revendications précédentes,
**caractérisé en ce que**
les informations secondaires (ZI) représentent notamment le début ou la fin d'une unité de données logique, un élément de données neutre pour le remplissage, l'émetteur ou le récepteur d'une unité de données, des informations supplémentaires relatives au type de codage des longueurs de projection utilisées, des informations supplémentaires pour la détection des erreurs ou des informations supplémentaires pour la gestion générale de bus.
